# EUROPEAN PATENT APPLICATION

(11) **EP 4 807 748 A1**
(43) Date of publication of application: **16.09.2026**
(21) Application number: 25817729.4
(22) Date of filing: 20.06.2025
(51) Int. Cl.: G11C 29/56, G11C 29/14

(54) **TEST CIRCUIT, TEST METHOD AND CHIP STACK STRUCTURE**

(30) Priority: 31.10.2024 CN 202411533604
(71) Applicant: CXMT Corporation, Hefei, Anhui 230601 (CN)
(72) Inventor: CAO, Kanyu, Hefei, Anhui 230601 (CN); ZHANG, Jiarui, Hefei, Anhui 230601 (CN)
(74) Representative: Gulde & Partner
(86) International application number: PCT/CN2025/102347
(87) International publication number: WO 2026/091566

(57) **Abstract**

The present disclosure provides a test circuit, a test method, and a chip stacked structure. The test circuit is applied to a logic chip, and includes: a first register module, electrically connected to a first path and a first through silicon via of the logic chip, configured as a linear feedback shift register when a first test enable signal is at a first level, to receive a first test signal through the first path at a first speed, and configured as a common shift register when the first test enable signal is at a second level, to perform serial output on a value in the first register module according to a serial test protocol to obtain a first test result signal. The present disclosure facilitates at least speed tests of the logic chip before stacking, thereby reducing test costs.

## Description

### CROSS-REFERENCE TO RELATED APPLICATIONS

This application is based on and claims priority of the Chinese Patent Application No. 202411533604.2, filed with the China National Intellectual Property Administration on October 31, 2024 and entitled "TEST CIRCUIT, TEST METHOD, AND CHIP STACKED STRUCTURE" The above-referenced application is incorporated herein by reference in its entirety.

### TECHNICAL FIELD

Embodiments of the present disclosure relate to the field of semiconductor technologies, and in particular, to a test circuit, a test method, and a chip stacked structure.

### BACKGROUND

With the development of integrated circuit technologies, significant progress has been made in manufacturing processes of semiconductor devices. However, in recent years, various challenges such as a physical limit, an existing developing technology limit, and a storage electron density limit have been posed to the development of two-dimensional semiconductor technologies. In this context, to address the difficulties encountered by two-dimensional semiconductor devices and pursue lower manufacturing costs per memory cell, a bonding process (e.g., hybrid bonding Hybrid bonding, bumping Bumping, or wire bonding) may be employed to stack multiple chips to form a three-dimensional semiconductor device. A test of the three-dimensional semiconductor device, e.g., a high bandwidth memory (HBM, High Bandwidth Memory), has a long procedure and is complex, resulting in high test costs.

### SUMMARY

Embodiments of the present disclosure provide a test circuit, a test method, and a chip stacked structure, to facilitate at least speed tests of a logic chip before stacking, thereby reducing test costs.

According to a first aspect, an embodiment of the present disclosure provides a test circuit, applied to a logic chip, and including:
a first register module, electrically connected to a first path and a first through silicon via of the logic chip, configured as a linear feedback shift register when a first test enable signal is at a first level, to receive a first test signal through the first path at a first speed, and configured as a common shift register when the first test enable signal is at a second level, to perform serial output on a value in the first register module according to a serial test protocol to obtain a first test result signal.

In some embodiments, the test circuit further includes:
a second register module, electrically connected to a second path and a second through silicon via of the logic chip, and in a mode of testing a write path in the second path, configured as a linear feedback shift register when a second test enable signal is at the first level, to receive a second test signal through the write path in the second path at the first speed, and configured as a common shift register when the second test enable signal is at the second level, to perform serial output on a value in the second register module according to the serial test protocol to obtain a second test result signal; and in a mode of testing a read path in the second path, configured as a common shift register when the second test enable signal is at the second level, to write an initial value to the second register module according to the serial test protocol, and configured as a linear feedback shift register when the second test enable signal is at the first level, to generate pseudo-random data and output the pseudo-random data through the read path in the second path at the first speed.

In some embodiments, the first path is a command address path configured to transmit a command address signal of the logic chip, and the second path is a data path configured to transmit a data signal of the logic chip.

In some embodiments, the first path includes a first receiver, a command decoder, and a first sampling circuit. The first receiver is electrically connected to a command address port of the logic chip. The write path in the second path includes a second receiver, a first serial-to-parallel conversion circuit, and a first transmitter. The second receiver is electrically connected to a data port of the logic chip, and the first transmitter is electrically connected to the second through silicon via. The read path in the second path includes a third receiver, a second serial-to-parallel conversion circuit, and a second transmitter. The third receiver is electrically connected to the second through silicon via, and the second transmitter is electrically connected to the data port.

In some embodiments, the first test signal is sent by a host and is transmitted to the first register module through the command address port of the logic chip and the first path. The second test signal is sent by the host and is transmitted to the second register module through the data port of the logic chip and the write path in the second path. The pseudo-random data is transmitted to the host through the first transmitter, the read path in the second path, and the data port.

In some embodiments, the first test signal is sent by a test interface circuit of the logic chip and is transmitted to the first register module through the third transmitter electrically connected to the command address port and the first path. The second test signal is sent by the test interface circuit of the logic chip and is transmitted to the second register module through the second serial-to-parallel conversion circuit, the second transmitter, and the write path in the second path. The pseudo-random data is transmitted to a multi-input shift register of the logic chip through the first transmitter, the third receiver, and the second serial-to-parallel conversion circuit.

In some embodiments, the first register module includes:
a first input selection unit, configured to receive the first test signal through a first input terminal, receive, through a second input terminal, test data written according to the serial test protocol, receive the first test enable signal through a control terminal, output, through an output terminal when the first test enable signal is at the first level, a signal received by the first input terminal, and output, through the output terminal when the first test enable signal is at the second level, a signal received by the second input terminal;
a first clock selection unit, configured to receive a first clock signal through a first input terminal, receive a second clock signal through a second input terminal, output, when the first test enable signal is at the first level, a signal received by the first input terminal, and output, when the first test enable signal is at the second level, a signal received by the second input terminal, the first clock signal being configured to sample a command address signal of the logic chip, and the second clock signal being a clock signal under the serial test protocol; and
a first register unit, including a first AND gate, a second AND gate, a first XOR gate, a second XOR gate, and M single-edge triggered flip-flops, a first input terminal of the first AND gate receiving the first test enable signal, and a second input terminal being electrically connected to an output terminal of an Mth single-edge triggered flip-flop; a first input terminal of the first XOR gate being electrically connected to an output terminal of the first AND gate, and a second input terminal being electrically connected to the output terminal of the first input selection unit; a first input terminal of the second AND gate receiving the first test enable signal, and a second input terminal being electrically connected to the output terminal of the Mth single-edge triggered flip-flop; a first input terminal of the second XOR gate being electrically connected to an output terminal of the second AND gate, and a second input terminal being electrically connected to an output terminal of an Nth single-edge triggered flip-flop; and an input terminal of a 1st single-edge triggered flip-flop being electrically connected to an output terminal of the first XOR gate, an input terminal of an ith single-edge triggered flip-flop being electrically connected to an output terminal of an (i-1)th single-edge triggered flip-flop, an input terminal of an (N+1)th single-edge triggered flip-flop being electrically connected to an output terminal of the second XOR gate, an input terminal of a jth single-edge triggered flip-flop being electrically connected to an output terminal of a (j-1)th single-edge triggered flip-flop, the output terminal of the Mth single-edge triggered flip-flop outputting the first test result signal, and clock terminals of the M single-edge triggered flip-flops being electrically connected to an output terminal of the first clock selection unit, where M, N, i, and j are positive integers, M>N, 2≤i≤N, and (N+1)<j≤M.

In some embodiments, M=5 and N=2.

In some embodiments, the second register module includes:
a second input selection unit, configured to receive the second test signal through a first input terminal, receive, through a second input terminal, test data written according to the serial test protocol, receive the second test enable signal through a control terminal, output, through an output terminal when the second test enable signal is at the first level, a signal received by the first input terminal, and output, through the output terminal when the second test enable signal is at the second level, a signal received by the second input terminal;
a second clock selection unit, configured to receive a third clock signal through a first input terminal, receive a fourth clock signal through a second input terminal, receive a fifth clock signal through a third input terminal, output, through a first output terminal when the second test enable signal is at the second level, a signal received by the first input terminal, output, through the first output terminal when the second test enable signal is at the first level and in the mode of testing the write path in the second path, a signal received by the second input terminal, and output, through the first output terminal when the second test enable signal is at the first level and in the mode of testing the read path in the second path, a signal received by the third input terminal, the signal output by the first output terminal being denoted as a sixth clock signal, a signal output by a second output terminal being denoted as a seventh clock signal, a phase of the seventh clock signal being opposite to a phase of the sixth clock signal, the third clock signal being a clock signal under the serial test protocol, the fourth clock signal being a clock signal employed in the write path in the second path, and the fifth clock signal being a clock signal employed in the read path in the second path; and
a second register unit, including a third AND gate, a fourth AND gate, a third XOR gate, a fourth XOR gate, and A dual-edge triggered flip-flops, a first input terminal of the third AND gate receiving the second test enable signal, and a second input terminal being electrically connected to an output terminal of an Ath dual-edge triggered flip-flop; a first input terminal of the third XOR gate being electrically connected to an output terminal of the third AND gate, and a second input terminal being electrically connected to the output terminal of the second input selection unit; a first input terminal of the fourth AND gate receiving the second test enable signal, and a second input terminal being electrically connected to the output terminal of the Ath dual-edge triggered flip-flop; a first input terminal of the fourth XOR gate being electrically connected to an output terminal of the fourth AND gate, and a second input terminal being electrically connected to an output terminal of a Bth dual-edge triggered flip-flop; and an input terminal of a 1st dual-edge triggered flip-flop being electrically connected to an output terminal of the third XOR gate, an input terminal of an xth dual-edge triggered flip-flop being electrically connected to an output terminal of an (x-1)th dual-edge triggered flip-flop, an input terminal of a (B+1)th dual-edge triggered flip-flop being electrically connected to an output terminal of the fourth XOR gate, an input terminal of a yth dual-edge triggered flip-flop being electrically connected to an output terminal of a (y-1)th dual-edge triggered flip-flop, the output terminal of the Ath dual-edge triggered flip-flop outputting the second test result signal or the pseudo-random data, and first clock terminals of the A dual-edge triggered flip-flops receiving the sixth clock signal and second clock terminals receiving the seventh clock signal, where A, B, x, and y are positive integers, A>B, 2≤x≤B, and (B+1)<y≤A.

In some embodiments, A=5 and B=2.

In some embodiments, the dual-edge triggered flip-flops perform, when the second test enable signal is at the second level, sampling in response to a rising edge of a clock signal received by the first clock terminals, and perform, when the second test enable signal is at the first level, sampling in response to the rising edge and a falling edge of the clock signal received by the first clock terminals.

In some embodiments, each of the dual-edge triggered flip-flops includes:
a first gated inverter, configured with an input terminal electrically connected to an input terminal of the dual-edge triggered flip-flop, and a control terminal electrically connected to a second clock terminal of the dual-edge triggered flip-flop;
a first inverter, configured with an input terminal electrically connected to a reset terminal of the dual-edge triggered flip-flop;
a first NOR gate, configured with a first input terminal electrically connected to an output terminal of the first gated inverter, and a second input terminal electrically connected to an output terminal of the first inverter;
a second gated inverter, configured with an input terminal electrically connected to an output terminal of the first NOR gate, and a control terminal electrically connected to a first clock terminal of the dual-edge triggered flip-flop;
a third gated inverter, configured with an input terminal electrically connected to the output terminal of the first NOR gate, a control terminal electrically connected to the first clock terminal of the dual-edge triggered flip-flop, and an output terminal electrically connected to the first input terminal of the first NOR gate;
a second inverter, configured with an input terminal electrically connected to an output terminal of the second gated inverter, and an output terminal electrically connected to an output terminal of the dual-edge triggered flip-flop;
a fourth gated inverter, configured with an input terminal electrically connected to the input terminal of the dual-edge triggered flip-flop, and a control terminal electrically connected to the first clock terminal of the dual-edge triggered flip-flop;
a fifth AND gate, configured with a first input terminal electrically connected to the second test enable signal, a second input terminal electrically connected to an output terminal of the fourth gated inverter, and an output terminal electrically connected to a second input terminal of a second NOR gate;
the second NOR gate, configured with a first input terminal electrically connected to an output terminal of a first NAND gate;
a fifth gated inverter, configured with an input terminal electrically connected to an output terminal of the second NOR gate, a control terminal electrically connected to the second clock terminal of the dual-edge triggered flip-flop, and an output terminal electrically connected to the input terminal of the second inverter;
a sixth gated inverter, configured with an input terminal electrically connected to the output terminal of the second NOR gate, a control terminal electrically connected to the second clock terminal of the dual-edge triggered flip-flop, and an output terminal electrically connected to the second input terminal of the fifth AND gate;
a first OR gate, configured with a first input terminal electrically connected to the second test enable signal, and a second input terminal electrically connected to the output terminal of the dual-edge triggered flip-flop; and
the first NAND gate, configured with a first input terminal electrically connected to the reset terminal of the dual-edge triggered flip-flop, and a second input terminal electrically connected to an output terminal of the first OR gate.

In some embodiments, the serial test protocol is an IEEE 1500 test protocol.

According to a second aspect, an embodiment of the present disclosure provides a test method, applied to a logic chip, and including the steps as follows.

A first test signal is written to a first register module of the logic chip through a first path of the logic chip at a first speed.

The first register module is controlled to operate in a mode of a linear feedback shift register.

The first register module is controlled to operate in a mode of a common shift register, to perform serial output on a value in the first register module according to a serial test protocol, to obtain a first test result signal.

The first test result signal is compared with an expected value to determine whether the first path of the logic chip is capable of working normally at the first speed.

The first register module is electrically connected to a first through silicon via of the logic chip.

In some embodiments, the test method further includes the steps as follows.

A second test signal is written to a second register module of the logic chip through a write path in a second path of the logic chip at the first speed.

The second register module is controlled to operate in a mode of a linear feedback shift register.

The second register module is controlled to operate in a mode of a common shift register, to perform serial output on a value in the second register module according to the serial test protocol, to obtain a second test result signal.

The second test result signal is compared with an expected value to determine whether the write path in the second path of the logic chip is capable of working normally at the first speed.

The second register module is electrically connected to a second through silicon via of the logic chip.

In some embodiments, the test method further includes the steps as follows.

The second register module is controlled to operate in a mode of a common shift register, to write an initial value to the second register module according to the serial test protocol.

The second register module is controlled to operate in a mode of a linear feedback shift register, to generate pseudo-random data.

The pseudo-random data is output through a read path in the second path at the first speed.

The pseudo-random data is compared with an expected value to determine whether the read path in the second path of the logic chip is capable of working normally at the first speed.

According to a third aspect, an embodiment of the present disclosure provides a chip stacked structure, including a logic chip and at least one stacked unit. The logic chip and the at least one stacked unit are stacked in a first direction in sequence. Each stacked unit includes several memory chips stacked in the first direction in sequence. The first direction is perpendicular to a top surface of each of the memory chips.

The logic chip includes the test circuit according to the first aspect.

The technical solutions provided in the embodiments of the present disclosure have at least the following advantages:

The test circuit is designed for speed tests of the logic chip, so that some tests of an HBM apparatus are shifted forward, that is, the logic chip is tested before stacking, to select a logic chip whose speed is qualified, and the logic chip is stacked with the memory chips. In this way, test costs and stacking costs can be greatly reduced.

### BRIEF DESCRIPTION OF DRAWINGS

One or more embodiments are exemplified with the figures in the accompanying drawings corresponding to the one or more embodiments. These example descriptions are not intended to limit the embodiments. Elements with the same reference numerals in the accompanying drawings are similar elements, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.
FIG. 1 is a schematic diagram of a structure of each of a test circuit and a logic chip according to an embodiment of the present disclosure;
FIG. 2 is a schematic diagram of another structure of each of a test circuit and a logic chip according to an embodiment of the present disclosure;
FIG. 3 is a schematic diagram of a specific structure of each of a test circuit and a logic chip according to an embodiment of the present disclosure;
FIG. 4 is a schematic diagram of another specific structure of each of a test circuit and a logic chip according to an embodiment of the present disclosure;
FIG. 5 is a circuit diagram of a first register module according to an embodiment of the present disclosure;
FIG. 6a is an equivalent circuit diagram of a first register unit in a case;
FIG. 6b is an equivalent circuit diagram of a first register unit in another case;
FIG. 7 is a circuit diagram of a second register module according to an embodiment of the present disclosure;
FIG. 8 is an equivalent circuit diagram of a second register unit in a case;
FIG. 9 is a circuit diagram of a dual-edge triggered flip-flop according to an embodiment of the present disclosure;
FIG. 10 is a flowchart of a test method according to an embodiment of the present disclosure;
FIG. 11 is a flowchart of another test method according to an embodiment of the present disclosure;
FIG. 12 is a flowchart of still another test method according to an embodiment of the present disclosure; and
FIG. 13 is a schematic diagram of a chip stacked structure according to an embodiment of the present disclosure.

### DESCRIPTION OF EMBODIMENTS

The technical solutions in the embodiments of the present disclosure are clearly described below with reference to the accompanying drawings in the embodiments of the present disclosure. It may be understood that specific embodiments described herein are merely intended to explain the related application, but are not intended to limit this application. In addition, it should be further noted that for ease of description, parts related to the related application are shown in the accompanying drawings. Unless otherwise defined, technical and scientific terms adopted in this specification have meanings the same as those commonly understood by a person skilled in the technical field of the present disclosure. The terms employed in this specification are merely intended to describe the embodiments of the present disclosure, but are not intended to limit the present disclosure. "Some embodiments" describing a subset of possible embodiments is involved in the following descriptions. However, it may be understood that "some embodiments" may be the same subset or different subsets of the possible embodiments, and may be combined with each other when there is no conflict. It should be noted that the term "first/second/third" in the embodiments of the present disclosure is merely intended to distinguish between similar objects, and does not represent specific sorting for the objects. It may be understood that "first/second/third" may be interchanged for a specific sequence or order if allowed, so that the embodiments of the present disclosure described herein can be implemented in a sequence other than those shown or described herein.
Dynamic random access memory (Dynamic Random Access Memory, DRAM)
Synchronous dynamic random access memory (Synchronous Dynamic Random Access Memory, SDRAM)
Double data rate SDRAM (Double Data Rate SDRAM, DDR)
Low power DDR (Low Power DDR, LPDDR)
High bandwidth memory (High Bandwidth Memory, HBM)
Through silicon via (Through Silicon Via, TSV)
Command (Command, CMD)
Linear feedback shift register (Linear Feedback Shift Register, LFSR)
Multi-input shift register (Multi-input Shift Register, MISR)

An HBM apparatus includes a logic chip and a memory chip stacked together. A test of the HBM apparatus has a long procedure and is complex. Speed-related tests of the HBM apparatus are mainly performed after the logic chip and the memory chip are stacked. In this case, the logic chip and the memory chip that are stacked can be discarded together if it is found that speeds of some apparatuses do no reach a standard, resulting in high test costs.

Based on this, an embodiment of the present disclosure provides a test circuit. The test circuit is applied to a logic chip, and includes: a first register module, electrically connected to a first path and a first through silicon via of the logic chip, configured as a linear feedback shift register when a first test enable signal is at a first level, to receive a first test signal through the first path at a first speed, and configured as a common shift register when the first test enable signal is at a second level, to perform serial output on a value in the first register module according to a serial test protocol to obtain a first test result signal. In this way, the test circuit is designed for speed tests of the logic chip, so that some tests of an HBM apparatus are shifted forward, that is, the logic chip is tested before stacking, to select a logic chip whose speed is qualified, and the logic chip is stacked with memory chips. In this way, test costs and stacking costs can be greatly reduced.

The following describes the embodiments of the present disclosure in detail with reference to the accompanying drawings.

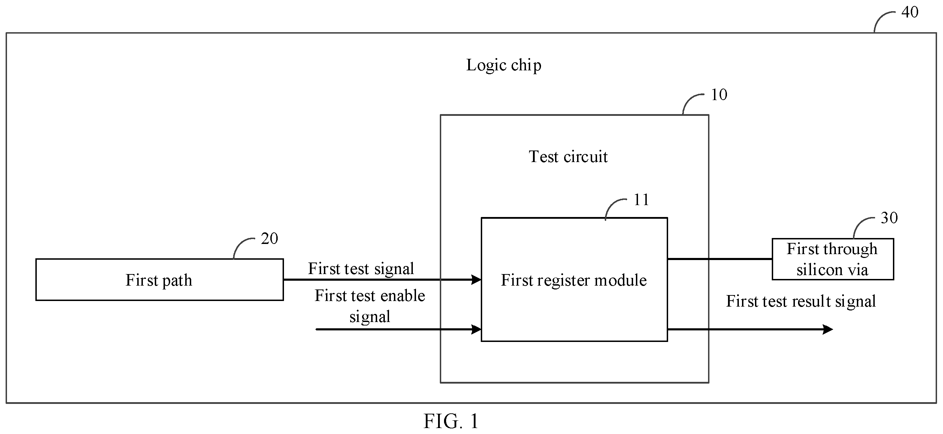

In an embodiment of the present disclosure, referring to FIG. 1, which is a schematic diagram of a structure of a logic chip 40 according to an embodiment of the present disclosure. The logic chip 40 includes a test circuit 10. As shown in FIG. 1, the test circuit 10 includes:
a first register module 11, electrically connected to a first path 20 and a first through silicon via 30 of the logic chip 40, configured as a linear feedback shift register (Linear Feedback Shift Register, LFSR) when a first test enable signal is at a first level, to receive a first test signal through the first path 20 at a first speed, and configured as a common shift register when the first test enable signal is at a second level, to perform serial output on a value in the first register module 11 according to a serial test protocol to obtain a first test result signal.

When a speed test is performed on the first path 20 of the logic chip 40, the logic chip 40 may be configured to operate at the first speed. The first test signal is written to the first register module 11 through the first path 20 at the first speed. In this case, the first test enable signal is set to the first level, and the first register module 11 is configured as the LFSR. A working principle of the LFSR is that different output data is generated in different clock cycles based on input signals and the structure of the LFSR. The working principle of the LFSR is based on polynomial division. The structure of the LFSR represents a characteristic polynomial, that is, a divisor. Each of the input signals to the LFSR represents an exponent of a dividend in the polynomial division, while the output data represents an exponent of a remainder in the polynomial division. A quantity of bits in the output data is equal to a quantity of D flip-flops DFF in the structure of the LFSR. For example, the LFSR outputs 5-bit data if the LFSR includes five DFFs. If the first test signal includes 16-bit data, the LFSR receives the 16-bitregister module 11 is configured as the LFSR when the first test signal is written, to mainly compress data, thereby improving test efficiency. To improve test accuracy and reliability, a large amount of data needs to be written to the first path 20. If the data is not compressed, an extremely large amount of test data is output. In addition, because the logic chip has multiple through silicon vias, test efficiency is low. Regardless of the quantity of bits of data in the first test signal, a quantity of bits output through the LFSR is fixed, and is determined based on the structure of the LFSR, as described above. For example, the LFSR outputs 5-bit data if the LFSR includes five DFFs. In this case, regardless of an amount of data in the first test signal, the first register module 11 corresponding to the first through silicon via outputs 5-bit data, and the 5-bit data is multiplied by a quantity of through silicon vias in the logic chip 40 to obtain a total quantity of bits of test data output in the test mode based on the serial test protocol. In this way, an amount of data that needs to be tested can be greatly compressed through the LFSR, thereby improving test efficiency.

In some embodiments, the serial test protocol is an IEEE 1500 test protocol.

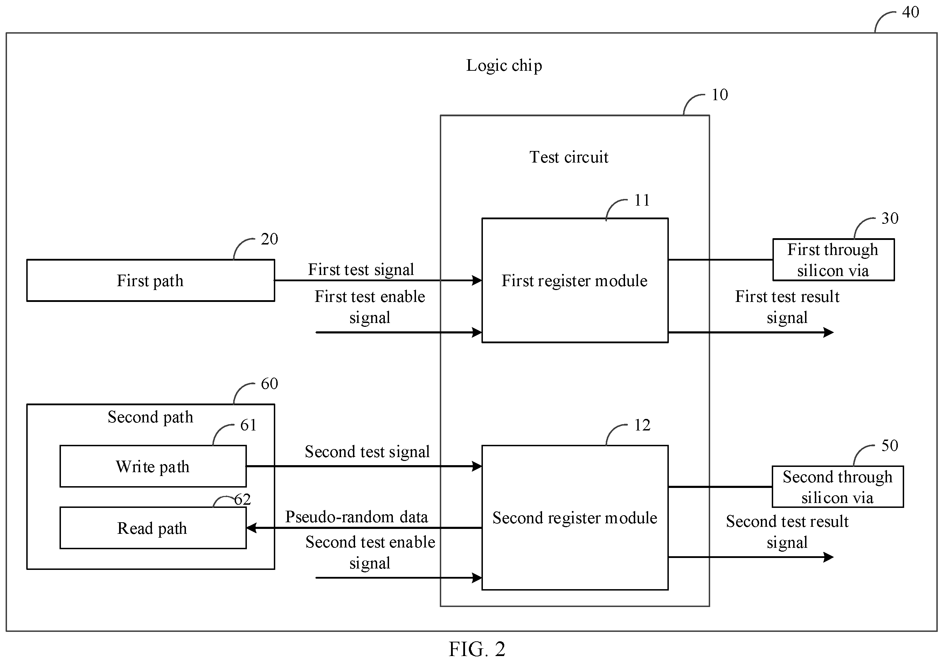

In some embodiments, as shown in FIG. 2, the test circuit 10 further includes:
a second register module 12, electrically connected to a second path 60 and a second through silicon via 50 of the logic chip 40, and in a mode of testing a write path 61 in the second path, configured as a linear feedback shift register when a second test enable signal is at the first level, to receive a second test signal through the write path 61 in the second path at the first speed, and configured as a common shift register when the second test enable signal is at the second level, to perform serial output on a value in the second register module 12 according to the serial test protocol to obtain a second test result signal; and in a mode of testing a read path 62 in the second path, configured as a common shift register when the second test enable signal is at the second level, to write an initial value to the second register module 12 according to the serial test protocol, and configured as a linear feedback shift register when the second test enable signal is at the first level, to generate pseudo-random data and output the pseudo-random data through the read path 62 in the second path at the first speed.

In some embodiments, the first path 20 is a command address path configured to transmit a command address signal of the logic chip 40, and the second path 60 is a data path configured to transmit a data signal of the logic chip 40.

A test manner in the mode of testing the write path 61 in the second path 60 is similar to that for testing the first path 20. When a speed test is performed on the write path 61 in the second path 60 of the logic chip 40, the logic chip 40 may be configured to operate at the first speed, to write the second test signal to the second register module 12 through the write path 61 in the second path 60 at the first speed. In this case, the second test enable signal is set to the first level, and the second register module 12 is configured as the LFSR. After the second test signal is received, the second test enable signal is set to the second level, and the second register module 12 is configured as the common shift register, to perform serial output on the value in the second register module 12 according to the serial test protocol, that is, perform serial output on a result of each DFF in the original LFSR, to obtain the second test result signal. If the second test result signal is consistent with an expected value, it indicates that the second test signal is transmitted to the second register module 12 through the write path 61 in the second path 60 at the first speed without an error, which means that the write path 61 in the second path 60 of the logic chip 40 can operate normally at the first speed, that is, passes a test at the first speed.

In the mode of testing the read path 62 in the second path, the second register module 12 is configured as the common shift register when the second test enable signal is at the second level, to write the initial value to the second register module 12 according to the serial test protocol. The initial value is a non-all-zero seed, that is, the initial value cannot be all 0. After the initial value is written, the second test enable signal is set to the first level, and the second register module 12 is configured as the LFSR, so that the LFSR can transition between 2ⁿ-1 states to generate the pseudo-random data. n is a quantity of DFFs in the LFSR. The pseudo-random data is output through the read path 62 in the second path 60 at the first speed, and is compared with an expected value. If the output pseudo-random data is consistent with the expected value, it indicates that the data is output through the read path 62 in the second path 60 without an error, which means that the read path 62 in the second path 60 of the logic chip 40 can operate normally at the first speed, that is, passes a test at the first speed.

The test circuit 10 is designed to test the first path 20 and the second path 60 of the logic chip 40, that is, the command address path and the data path, at various speeds. When both the first path 20 and the second path 60 pass the speed tests, it indicates that the logic chip 40 can operate normally at this speed. In this way, a logic chip whose speed is qualified can be selected, and the logic chip is stacked with memory chips. In this way, test costs and stacking costs can be greatly reduced.

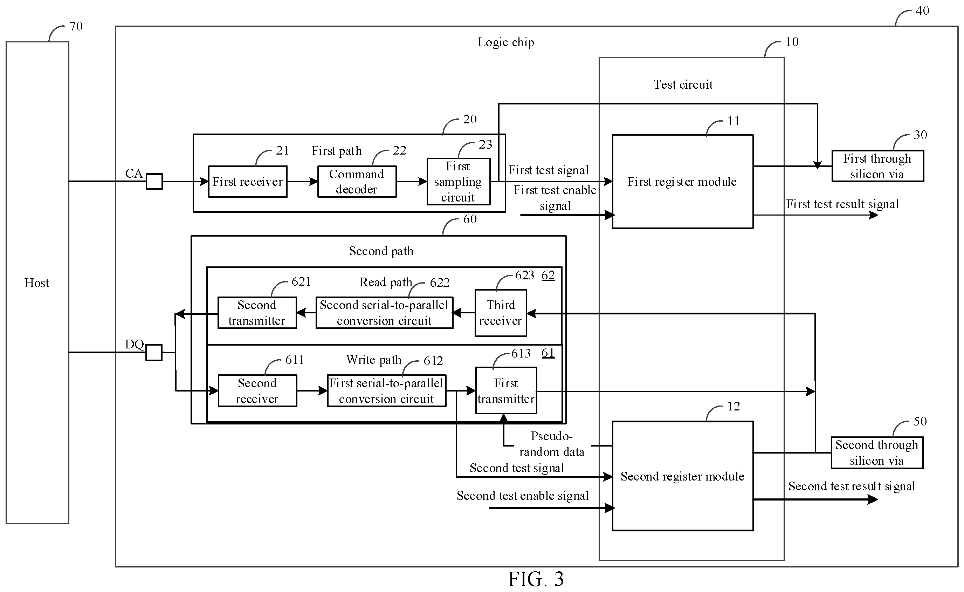

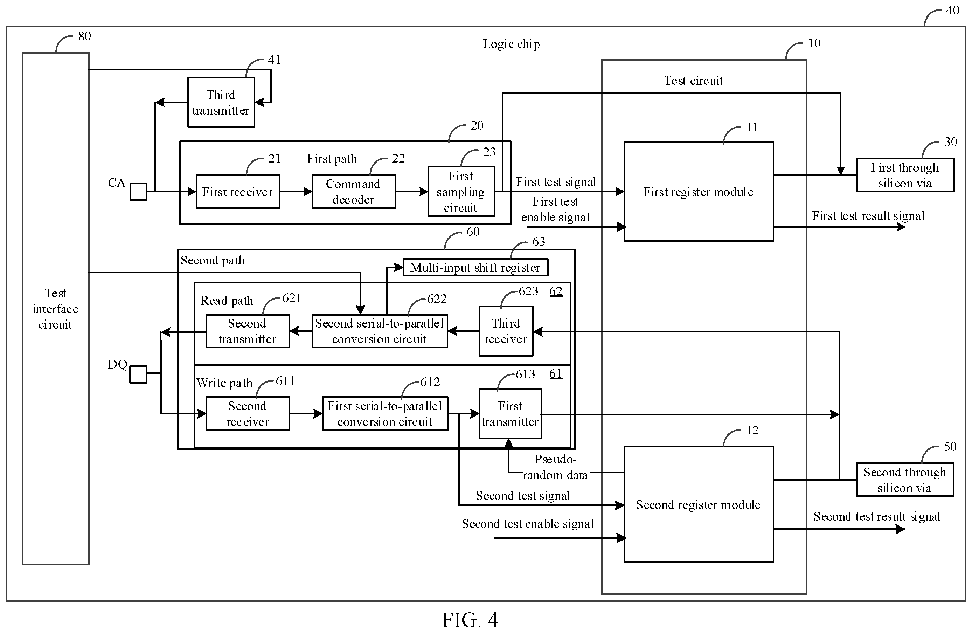

In some embodiments, as shown in FIG. 3 and FIG. 4, the first path 20 includes a first receiver 21, a command decoder 22, and a first sampling circuit 23. The first receiver 21 is electrically connected to a command address port CA of the logic chip 40. The write path 61 in the second path 60 includes a second receiver 611, a first serial-to-parallel conversion circuit 612, and a first transmitter 613. The second receiver 611 is electrically connected to a data port DQ of the logic chip 40, and the first transmitter 613 is electrically connected to the second through silicon via 50. The read path 62 in the second path 60 includes a third receiver 623, a second serial-to-parallel conversion circuit 622, and a second transmitter 621. The third receiver 623 is electrically connected to the second through silicon via 50, and the second transmitter 621 is electrically connected to the data port DQ.

The first receiver 21 in the first path 20 is electrically connected to the command address port CA of the logic chip 40, and is configured to receive a command address signal. The command decoder 22 decodes the command address signal to obtain a corresponding command or a specific address. The first sampling circuit 23 samples the decoded command or address to synchronize with a clock, and also sends the sampled command or address to the first through silicon via 30. The second receiver 611 in the second path 60 is electrically connected to the data port DQ of the logic chip 40, and is configured to receive a data signal. The first serial-to-parallel conversion circuit 612 performs serial-to-parallel conversion on data in the write path 61. The first transmitter 613 is electrically connected to the second through silicon via 50 to drive output data. The third receiver 623 in the read path 62 is electrically connected to the second through silicon via 50, and is configured to receive data from the second through silicon via 50. The second serial-to-parallel conversion circuit 622 performs parallel-to-serial conversion on data in the read path 62. The second transmitter 621 is electrically connected to the data port DQ to drive the data.

In some embodiments, as shown in FIG. 3, the first test signal is sent by a host 70 and is transmitted to the first register module 11 through the command address port CA of the logic chip 40 and the first path 20. The second test signal is sent by the host 70 and is transmitted to the second register module 12 through the data port DQ of the logic chip 40 and the write path 61 in the second path 60. The pseudo-random data is transmitted to the host 70 through the first transmitter 613, the read path 62 in the second path 60, and the data port DQ. The pseudo-random data can be received because the first transmitter 613 is electrically connected to the second register module 12. An output terminal of the first transmitter 613 is electrically connected to the second through silicon via 50, and an input terminal of the third receiver 623 is also electrically connected to the second through silicon via 50. Therefore, the pseudo-random data can be sent to the read path 62 in the second path 60 through the first transmitter 613.

In some embodiments, as shown in FIG. 4, the first test signal is sent by a test interface circuit 80 of the logic chip 40 and is transmitted to the first register module 11 through the third transmitter 41 electrically connected to the command address port CA and the first path 20. The second test signal is sent by the test interface circuit 80 of the logic chip 40 and is transmitted to the second register module 12 through the second serial-to-parallel conversion circuit 622, the second transmitter 621, and the write path 61 in the second path 60. The pseudo-random data is transmitted to a multi-input shift register 63 of the logic chip 40 through the first transmitter 613, the third receiver 623, and the second serial-to-parallel conversion circuit 622.

To prevent the command address port CA and the data port DQ from being connected to circuits of a large quantity, which increases a capacitive load and affects quality of signal reception, the test interface circuit 80 on the logic chip 40 does not directly send a test signal to the command address port CA and the data port DQ. Because an output terminal of the third transmitter 41 is electrically connected to the command address port CA and an input terminal of the first receiver 21 is electrically connected to the command address port CA, the output terminal of the third transmitter 41 is electrically connected to the input terminal of the first receiver 21, and the first test signal can be sent to the first path 20 through the third transmitter 41 and transmitted to the first register module 11. Because the second test signal sent by the test interface circuit 80 is parallel data, parallel-to-serial conversion is first performed on the second test signal through the second serial-to-parallel conversion circuit 622. Because an output terminal of the second transmitter 621 and an input terminal of the second receiver 611 are both electrically connected to the data port DQ, the second test signal can be sent to the write path 61 in the second path through the second transmitter 621 and transmitted to the second register module 12. The pseudo-random data is transmitted to the multi-input shift register 63 of the logic chip 40 through the first transmitter 613, the third receiver 623, and the second serial-to-parallel conversion circuit 622, and is compared with the expected value in the multi-input shift register MISR.

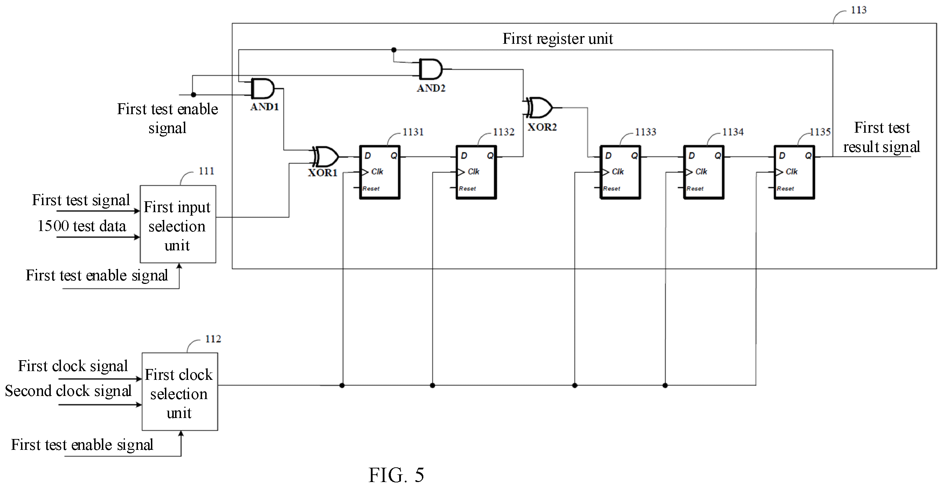

In some embodiments, as shown in FIG. 5, the first register module 11 includes:
a first input selection unit 111, configured to receive the first test signal through a first input terminal, receive, through a second input terminal, test data written according to the serial test protocol, receive the first test enable signal through a control terminal, output, through an output terminal when the first test enable signal is at the first level, a signal received by the first input terminal, and output, through the output terminal when the first test enable signal is at the second level, a signal received by the second input terminal;
a first clock selection unit 112, configured to receive a first clock signal through a first input terminal, receive a second clock signal through a second input terminal, output, when the first test enable signal is at the first level, a signal received by the first input terminal, and output, when the first test enable signal is at the second level, a signal received by the second input terminal, the first clock signal being configured to sample a command address signal of the logic chip, and the second clock signal being a clock signal under the serial test protocol; and
a first register unit 113, including a first AND gate AND1, a second AND gate AND2, a first XOR gate XOR1, a second XOR gate XOR2, and M single-edge triggered flip-flops (exemplarily shown as 1131, 1132, 1133, 1134, and 1135 in the figure), a first input terminal of the first AND gate AND1 receiving the first test enable signal, and a second input terminal being electrically connected to an output terminal of an Mth single-edge triggered flip-flop; a first input terminal of the first XOR gate XOR1 being electrically connected to an output terminal of the first AND gate AND1, and a second input terminal being electrically connected to the output terminal of the first input selection unit; a first input terminal of the second AND gate AND2 receiving the first test enable signal, and a second input terminal being electrically connected to the output terminal of the Mth single-edge triggered flip-flop; a first input terminal of the second XOR gate XOR2 being electrically connected to an output terminal of the second AND gate AND2, and a second input terminal being electrically connected to an output terminal of an Nth single-edge triggered flip-flop; and an input terminal of a 1st single-edge triggered flip-flop being electrically connected to an output terminal of the first XOR gate XOR1, an input terminal of an ith single-edge triggered flip-flop being electrically connected to an output terminal of an (i-1)th single-edge triggered flip-flop, an input terminal of an (N+1)th single-edge triggered flip-flop being electrically connected to an output terminal of the second XOR gate XOR2, an input terminal of a jth single-edge triggered flip-flop being electrically connected to an output terminal of a (j-1)th single-edge triggered flip-flop, the output terminal of the Mth single-edge triggered flip-flop outputting the first test result signal, and clock terminals of the M single-edge triggered flip-flops being electrically connected to an output terminal of the first clock selection unit, where M, N, i, and j are positive integers, M>N, 2≤i≤N, and (N+1)<j≤M.

It may be understood that the first register module 11 is configured as the LFSR when the first test enable signal is at the first level, and needs to receive the first test signal. Therefore, the first input selection unit 111 outputs the first test signal to the first register unit 113, and the first clock selection unit 112 outputs the first clock signal to the first register unit 113. The first clock signal is configured to sample the command address signal of the logic chip. Because the first path is a command address path and is configured to transmit the command address signal of the logic chip, when a test is performed and the first path transmits the first test signal, the first clock signal is also configured to sample the first test signal, and the first register unit 113 also employs the first clock signal, thereby facilitating smooth reception of the first test signal. The first register module 11 is configured as the common shift register when the first test enable signal is at the second level, and needs to perform serial output on the value in the first register unit 113 according to the serial test protocol to obtain the first test result signal. Therefore, the first clock selection unit 112 outputs the second clock signal. The second clock signal is a clock signal under the serial test protocol. The first input selection unit 111 outputs test data written according to the serial test protocol. However, in this case, because serial output needs to be performed on the value in the first register unit 113 according to the serial test protocol, the written test data is void, that is, no test data is written or a fixed value that does not affect serial output of the value in the first register unit 113 is written.

In some embodiments, M=5 and N=2. Referring to FIG. 5, the first register unit 113 is shown by taking M=5 and N=2 as an example. The M single-edge triggered flip-flops may include D flip-flops. Reset terminals of the D flip-flops may be connected to a reset signal of the logic chip, a reset signal representing that a tests ends, or the like, which is not specifically shown in the figure.

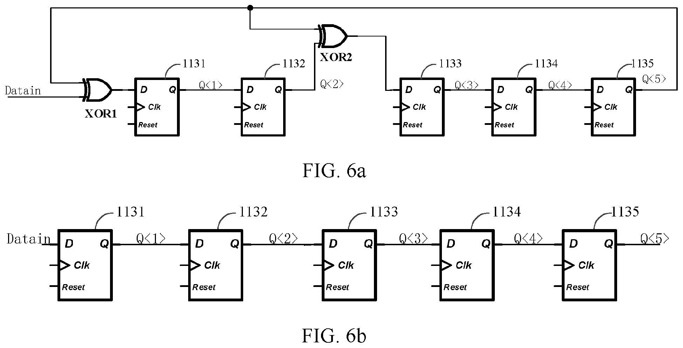

For example, the first level is a high level and the second level is a low level. The first register unit 113 is configured as an LFSR when the first test enable signal is at the first level, and an equivalent circuit thereof is shown in FIG. 6a. The first test signal enters the LFSR from the second input terminal Datain of the first XOR gate XOR1. For example, M=5 and N=2. A characteristic polynomial of the LFSR is P(x)=x⁵+x²+1. As described above, the working principle of the LFSR is based on polynomial division. The structure of the LFSR represents a characteristic polynomial, that is, a divisor. Each of the input signals to the LFSR represents an exponent of a dividend in the polynomial division, while the output data represents an exponent of a remainder in the polynomial division. A quantity of bits in the output data is equal to a quantity of D flip-flops DFF in the structure of the LFSR. The following Table 1 shows a specific example. Datain represents each step (step), that is, one bit of data in the first test signal received in each clock cycle, and Q<1> to Q<5> represent an output of each single-edge triggered flip-flop in the LFSR. In the example of Table 1, the first test signal includes 16-bit data 0110101100111010, which enters the LFSR in 16 clock cycles. After the end of the 16 clock cycles, data Q<1> to Q<5> output by each DFF in the LFSR is 11100.

**Table 1**

| Step | Datain | Q<1> | Q<2> | Q<3> | Q<4> | Q<5> |
|---|---|---|---|---|---|---|
| 0 | 0 | 0 | 0 | 0 | 0 | 0 |
| 1 | 1 | 0 | 0 | 0 | 0 | 0 |
| 2 | 1 | 1 | 0 | 0 | 0 | 0 |
| 3 | 0 | 1 | 1 | 0 | 0 | 0 |
| 4 | 1 | 0 | 1 | 1 | 0 | 0 |
| 5 | 0 | 1 | 0 | 1 | 1 | 0 |
| 6 | 1 | 0 | 1 | 0 | 1 | 1 |
| 7 | 1 | 0 | 0 | 0 | 0 | 1 |
| 8 | 0 | 0 | 0 | 1 | 0 | 0 |
| 9 | 0 | 0 | 0 | 0 | 1 | 0 |
| 10 | 1 | D | 0 | 0 | 0 | 1 |
| 11 | 1 | 0 | 0 | 1 | 0 | 0 |
| 12 | 1 | 1 | 0 | 0 | 1 | 0 |
| 13 | 0 | 1 | 1 | 0 | 0 | 1 |
| 14 | 1 | 1 | 1 | 0 | 0 | 0 |
| 15 | 0 | 1 | 1 | 1 | 0 | 0 |

The first register unit 113 is configured as a common shift register when the first test enable signal is at the second level, and an equivalent circuit thereof is shown in FIG. 6b. Serial output is performed on the value in the first register unit 113 according to the serial test protocol, that is, serial output is performed on the data Q<1> to Q<5> output by each DFF in the original LFSR, to obtain the first test result signal.

It should be noted that connection of a clock terminal of each flip-flop is not specifically drawn because FIG. 6a and FIG. 6b mainly show the equivalent circuits of the first register unit 113 in different cases. In practice, the clock terminal of each flip-flop is connected to the output terminal of the first clock selection unit 112.

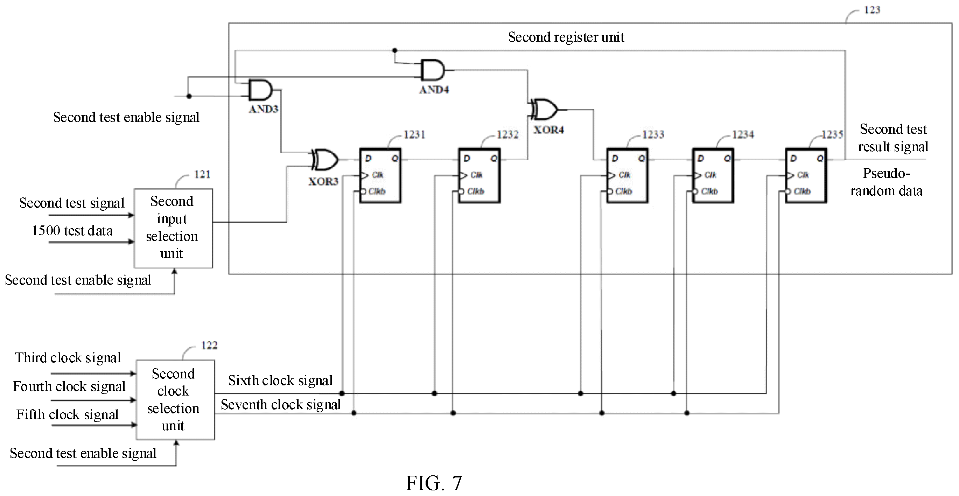

In some embodiments, as shown in FIG. 7, the second register module 12 includes:
a second input selection unit 121, configured to receive the second test signal through a first input terminal, receive, through a second input terminal, test data written according to the serial test protocol, receive the second test enable signal through a control terminal, output, through an output terminal when the second test enable signal is at the first level, a signal received by the first input terminal, and output, through the output terminal when the second test enable signal is at the second level, a signal received by the second input terminal;
a second clock selection unit 122, configured to receive a third clock signal through a first input terminal, receive a fourth clock signal through a second input terminal, receive a fifth clock signal through a third input terminal, output, through a first output terminal when the second test enable signal is at the second level, a signal received by the first input terminal, output, through the first output terminal when the second test enable signal is at the first level and in the mode of testing the write path 61 in the second path 60, a signal received by the second input terminal, and output, through the first output terminal when the second test enable signal is at the first level and in the mode of testing the read path 62 in the second path 60, a signal received by the third input terminal, the signal output by the first output terminal being denoted as a sixth clock signal, a signal output by a second output terminal being denoted as a seventh clock signal, a phase of the seventh clock signal being opposite to a phase of the sixth clock signal, the third clock signal being a clock signal under the serial test protocol, the fourth clock signal being a clock signal employed in the write path 61 in the second path 60, and the fifth clock signal being a clock signal employed in the read path 62 in the second path 60; and
a second register unit 123, including a third AND gate AND3, a fourth AND gate AND4, a third XOR gate XOR3, a fourth XOR gate XOR4, and A dual-edge triggered flip-flops (exemplarily shown as 1231, 1232, 1233, 1234, and 1235 in the figure), a first input terminal of the third AND gate AND3 receiving the second test enable signal, and a second input terminal being electrically connected to an output terminal of an Ath dual-edge triggered flip-flop; a first input terminal of the third XOR gate XOR3 being electrically connected to an output terminal of the third AND gate AND3, and a second input terminal being electrically connected to the output terminal of the second input selection unit; a first input terminal of the fourth AND gate AND4 receiving the second test enable signal, and a second input terminal being electrically connected to the output terminal of the Ath dual-edge triggered flip-flop; a first input terminal of the fourth XOR gate XOR4 being electrically connected to an output terminal of the fourth AND gate AND4, and a second input terminal being electrically connected to an output terminal of a Bth dual-edge triggered flip-flop; and an input terminal of a 1st dual-edge triggered flip-flop being electrically connected to an output terminal of the third XOR gate XOR3, an input terminal of an xth dual-edge triggered flip-flop being electrically connected to an output terminal of an (x-1)th dual-edge triggered flip-flop, an input terminal of a (B+1)th dual-edge triggered flip-flop being electrically connected to an output terminal of the fourth XOR gate XOR4, an input terminal of a yth dual-edge triggered flip-flop being electrically connected to an output terminal of a (y-1)th dual-edge triggered flip-flop, the output terminal of the Ath dual-edge triggered flip-flop outputting the second test result signal or the pseudo-random data, and first clock terminals of the A dual-edge triggered flip-flops receiving the sixth clock signal and second clock terminals receiving the seventh clock signal, where A, B, x, and y are positive integers, A>B, 2≤x≤B, and (B+1)<y≤A.

In some embodiments, A=5 and B=2. Referring to FIG. 7, the second register unit 123 is shown by taking A=5 and B=2 as an example.

In the mode of testing the write path 61 in the second path 60, the second register module 12 is configured as the LFSR when the second test enable signal is at the first level, and needs to receive the second test signal. Therefore, the second input selection unit 121 outputs the second test signal to the second register unit 123, and the second clock selection unit 122 outputs the fourth clock signal to the second register unit 123. The fourth clock signal is a clock signal employed in the write path 61 in the second path 60. In this way, the second register unit 123 and the write path 61 employ the same clock, which facilitates smooth reception of the second test signal. In this case, the second register unit 123 is configured as an LFSR, an equivalent circuit diagram thereof is also shown in FIG. 6a, and a working principle is similar to that of the foregoing first register unit 113. Details are not described herein again. In the mode of testing the write path 61 in the second path 60, the second clock selection unit 122 outputs the third clock signal when the second test enable signal is at the second level. The third clock signal is a clock signal under the serial test protocol. The second input selection unit 121 outputs test data written according to the serial test protocol. However, in this case, because serial output needs to be performed on the value in the second register unit 123 according to the serial test protocol, the written test data is void, that is, no test data is written or a fixed value that does not affect serial output of the value in the second register unit 123 is written. The second register unit 123 is configured as a common shift register, and an equivalent circuit diagram thereof is also shown in FIG. 6b. Serial output is performed on the value in the second register unit 123 according to the serial test protocol to obtain the second test result signal. It may be understood that, in the mode of testing the write path 61 in the second path 60, a working principle of the second register module 12 is similar to that of the first register module 11 for testing the first path 20.

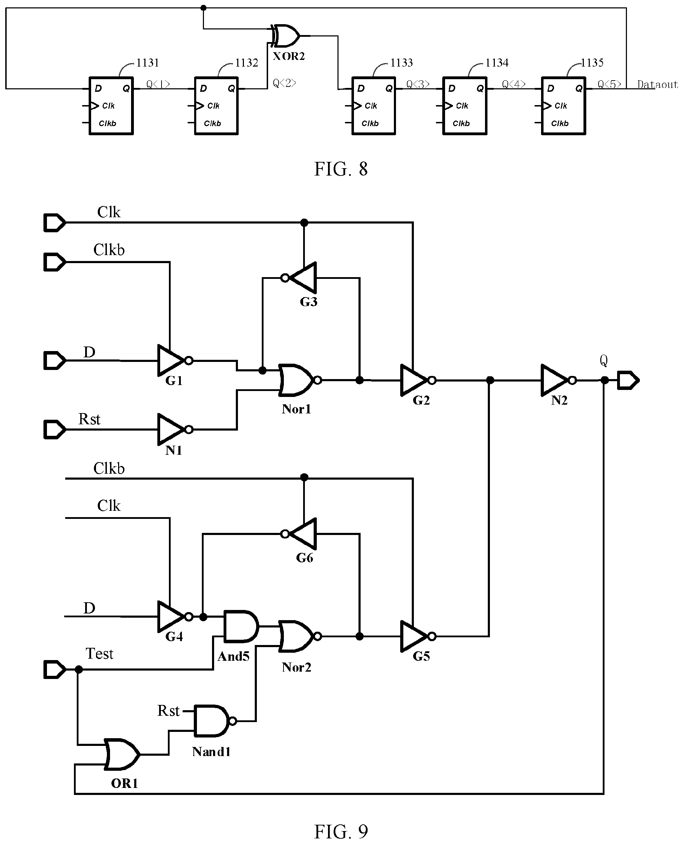

In the mode of testing the read path 62 in the second path 60, when the second test enable signal is at the second level, the second input selection unit 121 outputs the test data written according to the serial test protocol, and the second clock selection unit 122 outputs the third clock signal. The third clock signal is a clock signal under the serial test protocol. The second register unit 123 is configured as a common shift register, and an equivalent circuit diagram thereof is also shown in FIG. 6b. The initial value is written to the second register unit 123 through the second input selection unit 121 according to the serial test protocol. After the initial value is written, the second test enable signal is set to the first level, and the second input selection unit 121 outputs the second test signal to the second register unit 123. Because the read path is tested in this case, the second test signal is void or is a fixed value that does not affect operation of the LFSR in this case, e.g., 0. The second clock selection unit 122 outputs the fifth clock signal to the second register unit 123. The fifth clock signal is a clock signal employed in the read path 62 in the second path 60. In this way, the second register unit 123 and the read path 62 employ the same clock, thereby facilitating smooth output of data through the second register unit. In this case, the second register unit 123 is configured as an LFSR to generate the pseudo-random data, and an equivalent circuit diagram thereof is shown in FIG. 8. In this example, the LFSR includes five flip-flops. Therefore, the LFSR can transition between 31 states to generate the pseudo-random data. The following Table 2 shows a specific example. At step 0, an initial value 10000 is written, and Q<1> to Q<5> of an output of each flip-flop from step 1 to step 30 are shown in the table. At step 31, a value of Q<1> to Q<5> returns to 10000, and is adjusted between the 31 states again. The pseudo-random data output by the LFSR is Q<5> of an output of the last flip-flop.

**Table 2**

| Step | Q<1> | Q<2> | Q<3> | Q<4> | Q<5> |
|---|---|---|---|---|---|
| 0 | 1 | 0 | 0 | 0 | 0 |
| 1 | 0 | 1 | 0 | 0 | 0 |
| 2 | 0 | 0 | 1 | 0 | 0 |
| 3 | 0 | 0 | 0 | 1 | 0 |
| 4 | 0 | 0 | 0 | 0 | 1 |
| 5 | 1 | 0 | 1 | 0 | 0 |
| 6 | 0 | 1 | 0 | 1 | 0 |
| 7 | 0 | 0 | 1 | 0 | 1 |
| 8 | 1 | 0 | 1 | 1 | 0 |
| 9 | 0 | 1 | 0 | 1 | 1 |
| 10 | 1 | 0 | 0 | 0 | 1 |
| 11 | 1 | 1 | 1 | 0 | 0 |
| 12 | 0 | 1 | 1 | 1 | 0 |
| 13 | 0 | 0 | 1 | 1 | 1 |
| 14 | 1 | 0 | 1 | 1 | 1 |
| 15 | 1 | 1 | 1 | 1 | 1 |
| 16 | 1 | 1 | 0 | 1 | 1 |
| 17 | 1 | 1 | 0 | 0 | 1 |
| 18 | 1 | 1 | 0 | 0 | 0 |
| 19 | 0 | 1 | 1 | 0 | 0 |
| 20 | 0 | 0 | 1 | 1 | 0 |
| 21 | 0 | 0 | 0 | 1 | 1 |
| 22 | 1 | 0 | 1 | 0 | 1 |
| 23 | 1 | 1 | 1 | 1 | 0 |
| 24 | 0 | 1 | 1 | 1 | 1 |
| 25 | 1 | 0 | 0 | 1 | 1 |
| 26 | 1 | 1 | 1 | 0 | 1 |
| 27 | 1 | 1 | 0 | 1 | 0 |
| 28 | 0 | 1 | 1 | 0 | 1 |
| 29 | 1 | 0 | 0 | 1 | 0 |
| 30 | 0 | 1 | 0 | 0 | 1 |
| 31 | 1 | 0 | 0 | 0 | 0 |
| 32 | 0 | 1 | 0 | 0 | 0 |

It should be noted that connection of the clock terminal is not drawn because FIG. 8 mainly shows an equivalent circuit of the second register unit 123. In practice, the first clock terminal of each of the dual-edge triggered flip-flops receives the sixth clock signal, and the second clock terminal receives the seventh clock signal. The phase of the sixth clock signal is opposite to the phase of the seventh clock signal. Each of the dual-edge triggered flip-flops may further have a reset terminal, which is not shown in FIG. 7 and FIG. 8. The reset terminal may be connected to the reset signal of the logic chip, the reset signal representing that a test ends, or the like.

In some embodiments, the dual-edge triggered flip-flops perform, when the second test enable signal is at the second level, sampling in response to a rising edge of a clock signal received by the first clock terminals, and perform, when the second test enable signal is at the first level, sampling in response to the rising edge and a falling edge of the clock signal received by the first clock terminals. In the mode of testing the write path 61 or the read path 62 in the second path 60, reception of the second test signal or output of the pseudo-random data is performed in a highspeed mode. Therefore, the dual-edge triggered flip-flops need to perform sampling on both a rising edge and a falling edge of a clock. In the test mode based on the serial test protocol, regardless of serial output of the second test result signal or writing of the initial value, an extremely high speed is not required. Therefore, the dual-edge triggered flip-flops can perform sampling on the rising edge of the clock, thereby reducing power consumption.

In some embodiments, as shown in FIG. 9, each of the dual-edge triggered flip-flops includes:
a first gated inverter G1, configured with an input terminal electrically connected to an input terminal D of the dual-edge triggered flip-flop, and a control terminal electrically connected to a second clock terminal Clkb of the dual-edge triggered flip-flop;
a first inverter N1, configured with an input terminal electrically connected to a reset terminal Rst of the dual-edge triggered flip-flop;
a first NOR gate Nor1, configured with a first input terminal electrically connected to an output terminal of the first gated inverter G1, and a second input terminal electrically connected to an output terminal of the first inverter N1;
a second gated inverter G2, configured with an input terminal electrically connected to an output terminal of the first NOR gate Nor1, and a control terminal electrically connected to a first clock terminal Clk of the dual-edge triggered flip-flop;
a third gated inverter G3, configured with an input terminal electrically connected to the output terminal of the first NOR gate Nor1, a control terminal electrically connected to the first clock terminal Clk of the dual-edge triggered flip-flop, and an output terminal electrically connected to the first input terminal of the first NOR gate Nor1;
a second inverter N2, configured with an input terminal electrically connected to an output terminal of the second gated inverter G2, and an output terminal electrically connected to an output terminal Q of the dual-edge triggered flip-flop;
a fourth gated inverter G4, configured with an input terminal electrically connected to the input terminal D of the dual-edge triggered flip-flop, and a control terminal electrically connected to the first clock terminal Clk of the dual-edge triggered flip-flop;
a fifth AND gate And5, configured with a first input terminal electrically connected to the second test enable signal Test, a second input terminal electrically connected to an output terminal of the fourth gated inverter G4, and an output terminal electrically connected to a second input terminal of a second NOR gate Nor2;
the second NOR gate Nor2, configured with a first input terminal electrically connected to an output terminal of a first NAND gate Nand1;
a fifth gated inverter G5, configured with an input terminal electrically connected to an output terminal of the second NOR gate Nor2, a control terminal electrically connected to the second clock terminal Clkb of the dual-edge triggered flip-flop, and an output terminal electrically connected to the input terminal of the second inverter N2;
a sixth gated inverter G6, configured with an input terminal electrically connected to the output terminal of the second NOR gate Nor2, a control terminal electrically connected to the second clock terminal Clkb of the dual-edge triggered flip-flop, and an output terminal electrically connected to the second input terminal of the fifth AND gate And5;
a first OR gate OR1, configured with a first input terminal electrically connected to the second test enable signal Test, and a second input terminal electrically connected to the output terminal Q of the dual-edge triggered flip-flop; and
the first NAND gate Nand1, configured with a first input terminal electrically connected to the reset terminal Rst of the dual-edge triggered flip-flop, and a second input terminal electrically connected to an output terminal of the first OR gate OR1.

When the second test enable signal Test is at the high level, OR1 outputs the high level, an output of Nand1 depends on a signal of the reset terminal Rst, and the first input terminal of And5 receives the high level. When the reset terminal receives the high level without performing resetting, a flip-flop including G1, Nor1, G3, and G2 performs sampling on a rising edge of the first clock terminal Clk, and a flip-flop including G4, And5, Nor2, G6, and G5 performs sampling on a falling edge of the first clock terminal Clk, thereby implementing a dual-edge sampling function. When the second test enable signal Test is at the low level, And5 outputs the low level, and an output of G4 cannot be transmitted backward. Therefore, sampling cannot be performed on the falling edge of the first clock terminal Clk, the flip-flop including G1, Nor1, G3, and G2 performs sampling on the rising edge of the first clock terminal Clk, and Nor2, G5, N2, OR1, and Nand1 form a latch structure, thereby maintaining output.

In conclusion, in the test circuit provided in the embodiments of the present disclosure, a corresponding register module is designed in front of a through silicon via, to perform speed tests on the command address path and the read/write path in the data path in the logic chip. In this way, some tests of an HBM apparatus are shifted forward, that is, the logic chip is tested before stacking, to select a logic chip whose speed is qualified, and the logic chip is stacked with memory chips. In this way, test costs and stacking costs can be greatly reduced.

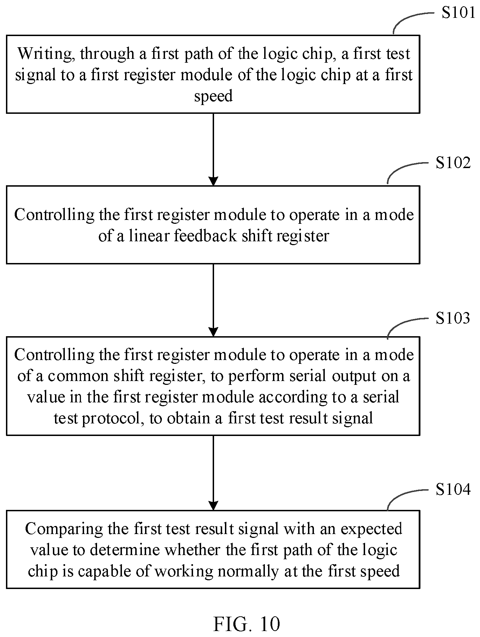

In another embodiment of the present disclosure, referring to FIG. 10, which is a schematic flowchart of a test method. As shown in FIG. 10, the method is applied to a logic chip, and includes the steps as follows.

In the step of S101, a first test signal is written to a first register module of the logic chip through a first path of the logic chip at a first speed.

In the step of S102, the first register module is controlled to operate in a mode of a linear feedback shift register.

In the step of S103, the first register module is controlled to operate in a mode of a common shift register, to perform serial output on a value in the first register module according to a serial test protocol, to obtain a first test result signal.

In the step of S104, the first test result signal is compared with an expected value to determine whether the first path of the logic chip is capable of working normally at the first speed.

The first register module is electrically connected to a first through silicon via of the logic chip.

If the first test result signal is consistent with the expected value, it indicates that the first test signal is transmitted to the first register module through the first path at the first speed without an error, which means that the first path of the logic chip can operate normally at the first speed, that is, passes a test at the first speed. It may be understood that different first speeds may be set. A value of the first speed is continuously increased to test a limiting speed at which the logic chip can operate normally. In this way, a logic chip whose speed is qualified is selected, and the logic chip is stacked with memory chips. In this way, test costs and stacking costs can be greatly reduced.

The logic chip includes multiple through silicon vias. A first register module corresponding to each of the through silicon vias can perform a speed test. In a test mode based on the serial test protocol, the through silicon vias may be connected in series, that is, serial output is performed on the first test result signal output by the first register module corresponding to each of the through silicon vias in sequence. Overall data output serially is compared with the expected value to determine whether the logic chip can operate normally at the first speed.

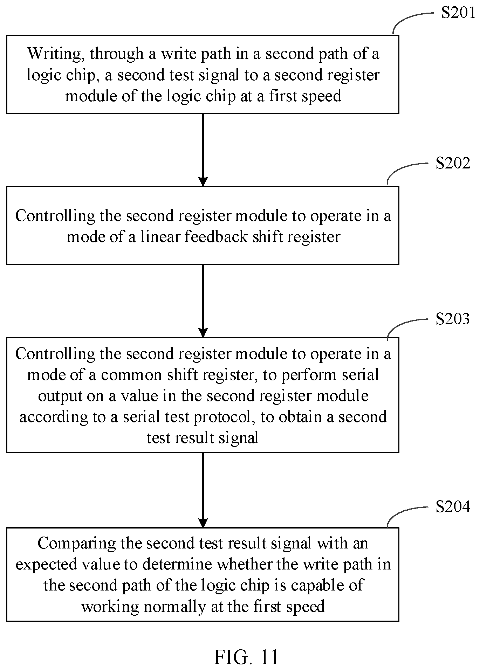

In some embodiments, referring to FIG. 11, the test method further includes the steps as follows.

In the step of S201, a second test signal is written to a second register module of the logic chip through a write path in a second path of the logic chip at the first speed.

In the step of S202, the second register module is controlled to operate in a mode of a linear feedback shift register.

In the step of S203, the second register module is controlled to operate in a mode of a common shift register, to perform serial output on a value in the second register module according to the serial test protocol, to obtain a second test result signal.

In the step of S204, the second test result signal is compared with an expected value to determine whether the write path in the second path of the logic chip is capable of working normally at the first speed.

The second register module is electrically connected to a second through silicon via of the logic chip.

If the second test result signal is consistent with an expected value, it indicates that the second test signal is transmitted to the second register module through the write path in the second path at the first speed without an error, which means that the write path in the second path of the logic chip can operate normally at the first speed, that is, passes a test at the first speed.

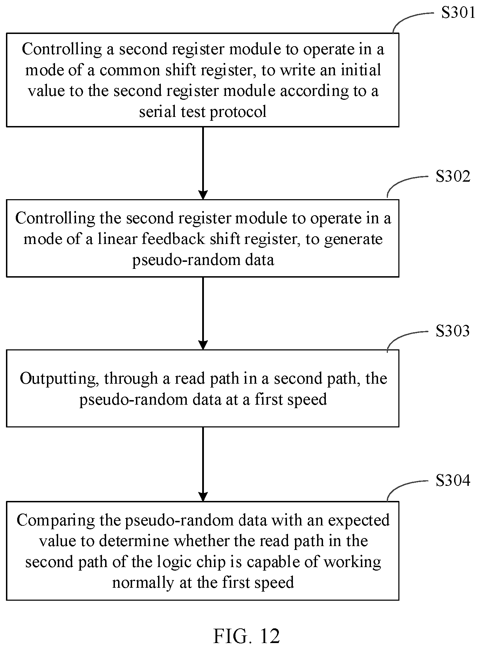

In some embodiments, referring to FIG. 12, the test method further includes the steps as follows.

In the step of S301, the second register module is controlled to operate in a mode of a common shift register, to write an initial value to the second register module according to the serial test protocol.

In the step of S302, the second register module is controlled to operate in a mode of a linear feedback shift register, to generate pseudo-random data.

In the step of S303, the pseudo-random data is output through a read path in the second path at the first speed.

In the step of S304, the pseudo-random data is compared with an expected value to determine whether the read path in the second path of the logic chip is capable of working normally at the first speed.

If the output pseudo-random data is consistent with the expected value, it indicates that the data is output through the read path in the second path without an error, which means that the read path in the second path of the logic chip can operate normally at the first speed, that is, passes a test at the first speed.

In some embodiments, the first path is a command address path configured to transmit a command address signal of the logic chip, and the second path is a data path configured to transmit a data signal of the logic chip.

According to the test method, the first path and the second path of the logic chip, that is, the command address path and the data path, may be tested at various speeds. When both the first path and the second path pass the speed tests, it indicates that the logic chip can operate normally at this speed. In this way, a logic chip whose speed is qualified can be selected, and the logic chip is stacked with memory chips. In this way, test costs and stacking costs can be greatly reduced.

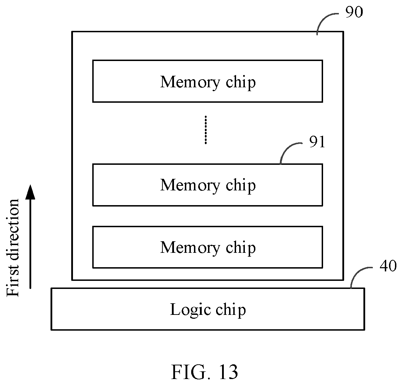

In still another embodiment of the present disclosure, referring to FIG. 13, which is a schematic diagram of a chip stacked structure.

As shown in FIG. 13, the chip stacked structure includes a logic chip 40 and at least one stacked unit 90. The logic chip 40 and the at least one stacked unit 90 are stacked in a first direction in sequence. Each stacked unit includes several memory chips 91 stacked in the first direction in sequence. The first direction is perpendicular to a top surface of each of the memory chips 91. The logic chip 40 includes the test circuit in the foregoing embodiments.

The logic chip 40 included in the chip stacked structure may undergo, before stacking, the foregoing speed tests by employing the test circuit included therein. A logic chip whose speed is qualified is stacked with the memory chips. In this way, the quality and the yield of the chip stacked structure can be ensured, thereby reducing test and stacking costs.

The foregoing embodiments are merely optional embodiments of the present disclosure, and are not intended to limit the protection scope of the present disclosure. It should be noted that in the present disclosure, the terms "include", "comprise", or any other variant thereof are intended to cover non-exclusive inclusion, so that a procedure, method, article, or apparatus that includes a series of elements includes not only those elements but also other elements that are not expressly listed, or further includes elements inherent to such a procedure, method, article, or apparatus. An element preceded by "includes a ..." does not, without more constraints, preclude the presence of additional identical elements in the process, method, article, or apparatus including the element. The sequence numbers of the foregoing embodiments of the present disclosure are merely for the purpose of description, and are not intended to indicate priorities of the embodiments. The methods disclosed in the several method embodiments provided in the present disclosure may be randomly combined when there is no conflict, to obtain new method embodiments. The features disclosed in the several product embodiments provided in the present disclosure may be randomly combined when there is no conflict, to obtain new product embodiments. The features disclosed in the several method or device embodiments provided in the present disclosure may be randomly combined when there is no conflict, to obtain new method embodiments or new device embodiments. The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A test circuit, applied to a logic chip (40), and comprising:
a first register module (11), electrically connected to a first path (20) and a first through silicon via (30) of the logic chip, configured as a linear feedback shift register when a first test enable signal is at a first level, to receive a first test signal through the first path at a first speed, and configured as a common shift register when the first test enable signal is at a second level, to perform serial output on a value in the first register module according to a serial test protocol to obtain a first test result signal.

2. The test circuit according to claim 1, further comprising:
a second register module (12), electrically connected to a second path (60) and a second through silicon via (50) of the logic chip, and in a mode of testing a write path in the second path, configured as a linear feedback shift register when a second test enable signal is at the first level, to receive a second test signal through the write path in the second path at the first speed, and configured as a common shift register when the second test enable signal is at the second level, to perform serial output on a value in the second register module according to the serial test protocol to obtain a second test result signal; and in a mode of testing a read path in the second path, configured as a common shift register when the second test enable signal is at the second level, to write an initial value to the second register module according to the serial test protocol, and configured as a linear feedback shift register when the second test enable signal is at the first level, to generate pseudo-random data and output the pseudo-random data through the read path in the second path at the first speed.

3. The test circuit according to claim 2, wherein the first path is a command address path configured to transmit a command address signal of the logic chip, and the second path is a data path configured to transmit a data signal of the logic chip.

4. The test circuit according to claim 3, wherein the first path comprises a first receiver (21), a command decoder (22), and a first sampling circuit (23), and the first receiver is electrically connected to a command address port of the logic chip; the write path in the second path comprises a second receiver, a first serial-to-parallel conversion circuit, and a first transmitter, the second receiver is electrically connected to a data port of the logic chip, and the first transmitter is electrically connected to the second through silicon via; and the read path in the second path comprises a third receiver, a second serial-to-parallel conversion circuit, and a second transmitter, the third receiver is electrically connected to the second through silicon via, and the second transmitter is electrically connected to the data port.

5. The test circuit according to claim 4, wherein the first test signal is sent by a host and is transmitted to the first register module through the command address port of the logic chip and the first path; the second test signal is sent by the host and is transmitted to the second register module through the data port of the logic chip and the write path in the second path; and the pseudo-random data is transmitted to the host through the first transmitter, the read path in the second path, and the data port.

6. The test circuit according to claim 4, wherein the first test signal is sent by a test interface circuit of the logic chip and is transmitted to the first register module through the third transmitter electrically connected to the command address port and the first path; the second test signal is sent by the test interface circuit of the logic chip and is transmitted to the second register module through the second serial-to-parallel conversion circuit, the second transmitter, and the write path in the second path; and the pseudo-random data is transmitted to a multi-input shift register of the logic chip through the first transmitter, the third receiver, and the second serial-to-parallel conversion circuit.

7. The test circuit according to claim 1, wherein the first register module comprises:
a first input selection unit (111), configured to receive the first test signal through a first input terminal, receive, through a second input terminal, test data written according to the serial test protocol, receive the first test enable signal through a control terminal, output, through an output terminal when the first test enable signal is at the first level, a signal received by the first input terminal, and output, through the output terminal when the first test enable signal is at the second level, a signal received by the second input terminal;
a first clock selection unit (112), configured to receive a first clock signal through a first input terminal, receive a second clock signal through a second input terminal, output, when the first test enable signal is at the first level, a signal received by the first input terminal, and output, when the first test enable signal is at the second level, a signal received by the second input terminal, the first clock signal being configured to sample a command address signal of the logic chip, and the second clock signal being a clock signal under the serial test protocol; and
a first register unit (113), comprising a first AND gate, a second AND gate, a first XOR gate, a second XOR gate, and M single-edge triggered flip-flops, a first input terminal of the first AND gate receiving the first test enable signal, and a second input terminal being electrically connected to an output terminal of an Mth single-edge triggered flip-flop; a first input terminal of the first XOR gate being electrically connected to an output terminal of the first AND gate, and a second input terminal being electrically connected to the output terminal of the first input selection unit; a first input terminal of the second AND gate receiving the first test enable signal, and a second input terminal being electrically connected to the output terminal of the Mth single-edge triggered flip-flop; a first input terminal of the second XOR gate being electrically connected to an output terminal of the second AND gate, and a second input terminal being electrically connected to an output terminal of an Nth single-edge triggered flip-flop; and an input terminal of a 1st single-edge triggered flip-flop being electrically connected to an output terminal of the first XOR gate, an input terminal of an ith single-edge triggered flip-flop being electrically connected to an output terminal of an (i-1)th single-edge triggered flip-flop, an input terminal of an (N+1)th single-edge triggered flip-flop being electrically connected to an output terminal of the second XOR gate, an input terminal of a jth single-edge triggered flip-flop being electrically connected to an output terminal of a (j-1)th single-edge triggered flip-flop, the output terminal of the Mth single-edge triggered flip-flop outputting the first test result signal, and clock terminals of the M single-edge triggered flip-flops being electrically connected to an output terminal of the first clock selection unit, wherein M, N, i, and j are positive integers, M>N, 2≤i≤N, and (N+1)<j≤M.

8. The test circuit according to claim 7, wherein M=5 and N=2.

9. The test circuit according to claim 2, wherein the second register module comprises:
a second input selection unit (121), configured to receive the second test signal through a first input terminal, receive, through a second input terminal, test data written according to the serial test protocol, receive the second test enable signal through a control terminal, output, through an output terminal when the second test enable signal is at the first level, a signal received by the first input terminal, and output, through the output terminal when the second test enable signal is at the second level, a signal received by the second input terminal;
a second clock selection unit (122), configured to receive a third clock signal through a first input terminal, receive a fourth clock signal through a second input terminal, receive a fifth clock signal through a third input terminal, output, through a first output terminal when the second test enable signal is at the second level, a signal received by the first input terminal, output, through the first output terminal when the second test enable signal is at the first level and in the mode of testing the write path in the second path, a signal received by the second input terminal, and output, through the first output terminal when the second test enable signal is at the first level and in the mode of testing the read path in the second path, a signal received by the third input terminal, the signal output by the first output terminal being denoted as a sixth clock signal, a signal output by a second output terminal being denoted as a seventh clock signal, a phase of the seventh clock signal being opposite to a phase of the sixth clock signal, the third clock signal being a clock signal under the serial test protocol, the fourth clock signal being a clock signal employed in the write path in the second path, and the fifth clock signal being a clock signal employed in the read path in the second path; and
a second register unit (123), comprising a third AND gate, a fourth AND gate, a third XOR gate, a fourth XOR gate, and A dual-edge triggered flip-flops, a first input terminal of the third AND gate receiving the second test enable signal, and a second input terminal being electrically connected to an output terminal of an Ath dual-edge triggered flip-flop; a first input terminal of the third XOR gate being electrically connected to an output terminal of the third AND gate, and a second input terminal being electrically connected to the output terminal of the second input selection unit; a first input terminal of the fourth AND gate receiving the second test enable signal, and a second input terminal being electrically connected to the output terminal of the Ath dual-edge triggered flip-flop; a first input terminal of the fourth XOR gate being electrically connected to an output terminal of the fourth AND gate, and a second input terminal being electrically connected to an output terminal of a Bth dual-edge triggered flip-flop; and an input terminal of a 1st dual-edge triggered flip-flop being electrically connected to an output terminal of the third XOR gate, an input terminal of an xth dual-edge triggered flip-flop being electrically connected to an output terminal of an (x-1)th dual-edge triggered flip-flop, an input terminal of a (B+1)th dual-edge triggered flip-flop being electrically connected to an output terminal of the fourth XOR gate, an input terminal of a yth dual-edge triggered flip-flop being electrically connected to an output terminal of a (y-1)th dual-edge triggered flip-flop, the output terminal of the Ath dual-edge triggered flip-flop outputting the second test result signal or the pseudo-random data, and first clock terminals of the A dual-edge triggered flip-flops receiving the sixth clock signal and second clock terminals receiving the seventh clock signal, wherein A, B, x, and y are positive integers, A>B, 2≤x≤B, and (B+1)<y≤A.

10. The test circuit according to claim 9, wherein A=5 and B=2.

11. The test circuit according to claim 9, wherein the dual-edge triggered flip-flops perform, when the second test enable signal is at the second level, sampling in response to a rising edge of a clock signal received by the first clock terminals, and perform, when the second test enable signal is at the first level, sampling in response to the rising edge and a falling edge of the clock signal received by the first clock terminals.

12. The test circuit according to claim 11, wherein each of the dual-edge triggered flip-flops comprises:
a first gated inverter, configured with an input terminal electrically connected to an input terminal of the dual-edge triggered flip-flop, and a control terminal electrically connected to a second clock terminal of the dual-edge triggered flip-flop;
a first inverter, configured with an input terminal electrically connected to a reset terminal of the dual-edge triggered flip-flop;
a first NOR gate, configured with a first input terminal electrically connected to an output terminal of the first gated inverter, and a second input terminal electrically connected to an output terminal of the first inverter;
a second gated inverter, configured with an input terminal electrically connected to an output terminal of the first NOR gate, and a control terminal electrically connected to a first clock terminal of the dual-edge triggered flip-flop;
a third gated inverter, configured with an input terminal electrically connected to the output terminal of the first NOR gate, a control terminal electrically connected to the first clock terminal of the dual-edge triggered flip-flop, and an output terminal electrically connected to the first input terminal of the first NOR gate;
a second inverter, configured with an input terminal electrically connected to an output terminal of the second gated inverter, and an output terminal electrically connected to an output terminal of the dual-edge triggered flip-flop;
a fourth gated inverter, configured with an input terminal electrically connected to the input terminal of the dual-edge triggered flip-flop, and a control terminal electrically connected to the first clock terminal of the dual-edge triggered flip-flop;
a fifth AND gate, configured with a first input terminal electrically connected to the second test enable signal, a second input terminal electrically connected to an output terminal of the fourth gated inverter, and an output terminal electrically connected to a second input terminal of a second NOR gate;
the second NOR gate, configured with a first input terminal electrically connected to an output terminal of a first NAND gate;
a fifth gated inverter, configured with an input terminal electrically connected to an output terminal of the second NOR gate, a control terminal electrically connected to the second clock terminal of the dual-edge triggered flip-flop, and an output terminal electrically connected to the input terminal of the second inverter;
a sixth gated inverter, configured with an input terminal electrically connected to the output terminal of the second NOR gate, a control terminal electrically connected to the second clock terminal of the dual-edge triggered flip-flop, and an output terminal electrically connected to the second input terminal of the fifth AND gate;
a first OR gate, configured with a first input terminal electrically connected to the second test enable signal, and a second input terminal electrically connected to the output terminal of the dual-edge triggered flip-flop; and
the first NAND gate, configured with a first input terminal electrically connected to the reset terminal of the dual-edge triggered flip-flop, and a second input terminal electrically connected to an output terminal of the first OR gate.

13. The test circuit according to claim 1, wherein the serial test protocol is an IEEE 1500 test protocol.

14. A test method, applied to a logic chip, and comprising:
writing, through a first path of the logic chip, a first test signal to a first register module of the logic chip at a first speed;
controlling the first register module to operate in a mode of a linear feedback shift register;
controlling the first register module to operate in a mode of a common shift register, to perform serial output on a value in the first register module according to a serial test protocol, to obtain a first test result signal; and
comparing the first test result signal with an expected value to determine whether the first path of the logic chip is capable of working normally at the first speed,
the first register module being electrically connected to a first through silicon via of the logic chip.

15. The test method according to claim 14, further comprising:
writing, through a write path in a second path of the logic chip, a second test signal to a second register module of the logic chip at the first speed;
controlling the second register module to operate in a mode of a linear feedback shift register;
controlling the second register module to operate in a mode of a common shift register, to perform serial output on a value in the second register module according to the serial test protocol, to obtain a second test result signal; and
comparing the second test result signal with an expected value to determine whether the write path in the second path of the logic chip is capable of working normally at the first speed,
the second register module being electrically connected to a second through silicon via of the logic chip.

16. The test method according to claim 15, further comprising:
controlling the second register module to operate in a mode of a common shift register, to write an initial value to the second register module according to the serial test protocol;
controlling the second register module to operate in a mode of a linear feedback shift register, to generate pseudo-random data;
outputting, through a read path in the second path, the pseudo-random data at the first speed; and
comparing the pseudo-random data with an expected value to determine whether the read path in the second path of the logic chip is capable of working normally at the first speed.

17. A chip stacked structure, comprising a logic chip and at least one stacked unit, the logic chip and the at least one stacked unit being stacked in a first direction in sequence, each stacked unit comprising several memory chips stacked in the first direction in sequence, and the first direction being perpendicular to a top surface of each of the memory chips; and
the logic chip comprising the test circuit according to any one of claims 1-13.
